# EUROPÄISCHE PATENTSCHRIFT

(11) **EP 1 309 420 B1**
(45) Veröffentlichungstag und Bekanntmachung des Hinweises auf die Patenterteilung: **28.09.2005**
(21) Anmeldenummer: 01956357.6
(22) Anmeldetag: 20.07.2001
(51) Int. Cl.: B23K 1/20, H05K 3/34, H01R 43/02

(54) **LÖTVERFAHREN ZUR BEFESTIGUNG ELEKTRISCHER BAUELEMENTE**
SOLDERING METHOD FOR MOUNTING ELECTRIC COMPONENTS
PROCEDE DE BRASAGE POUR LA FIXATION DE COMPOSANTS ELECTRIQUES

(30) Priorität: 05.08.2000 DE 10038330
(43) Veröffentlichungstag der Anmeldung: 14.05.2003
(73) Patentinhaber: ROBERT BOSCH GMBH, 70442 Stuttgart (DE)
(72) Erfinder: WOLF, Kuno, 72417 Jungingen (DE); WALLRAUCH, Alexander, 72810 Gomaringen (DE); MEINDERS, Horst, 72762 Reutlingen (DE); WILL, Barbara, 71083 Herrenberg (DE); URBACH, Peter, 72762 Reutlingen (DE)
(86) Internationale Anmeldenummer: PCT/DE2001/002756
(87) Internationale Veröffentlichungsnummer: WO 2002/014008

(56) Entgegenhaltungen:
- DE-B- 2 653 650
- US-A- 3 805 373
- US-A- 4 626 478

## Beschreibung

### Stand der Technik

Es ist bekannt, elektrische Bauelemente auf einer Unterlage unter Verwendung von Lot zu befestigen. Die bisher bekannten Verfahren haben jedoch den Nachteil, keine eng begrenzten Dickentoleranzen von unter 10 Mikrometern bei den Lotschichten gewährleisten zu können.

Aus der Schrift US 3,805,373 ist ein Verfahren zur Befestigung wenigstens eines elektrischen Bauelements auf einer Unterlage unter Verwendung von Lot bekannt. Bei diesem Verfahren werden Erhebungen mit einer festen Höhe über eine Walze in einer dünne Unterlage eingeprägt. Anschließend wird Lot zwischen diese Erhebungen gelegt und darauf ein Metallband aufgelegt, woraufhin die Verlötung erfolgt.

### Vorteile der Erfindung

Das erfindungsgemäße Verfahren mit den kennzeichnenden Merkmalen des Hauptanspruchs hat demgegenüber den Vorteil, daß über die Strukturierung der Lötunterlage gleichzeitig sowohl eine exakte Einstellung einer erwünschten Lotschichtdicke mit Toleranzen kleiner als 10 Mikrometer als auch eine Fixierung des Lots auf der Unterlage vor dem Lötprozess ermöglicht wird. Insbesondere vorteilhaft ist die direkte Verknüpfung der Höhe der Erhebungen mit der Dicke der Lotfolien. Dadurch können die Erhebungen mit sehr kleinen Höhentoleranzen relativ zur Unterlage und unabhängig von deren Dickentoleranzen hergestellt werden. Demzufolge können sehr genaue Lotschichtdicken bei der Lötung des Bauteils erzielt werden. Durch die Unterstützung des Bauteils durch die Erhebungen können zudem die Bauteile erheblich schwerer sein als das Lot ohne Erhebungen tragen könnte. Ferner stellt sich die Höhe der Erhebungen beim Niederdrücken selbstjustierend auf etwaige Dickenschwankungen der Lotfolie ein. Eine Lotmengendosierung erfolgt unabhängig vom Gewicht des Bauteils automatisch über die Kapillarkräfte. Ein weiterer Vorteil ist, dass durch die sehr kleinen Höhentoleranzen der Erhebungen zueinander auch keilige Lötungen vermieden werden können, da das Bauteil während der Schmelzphase des Lotes zu keiner Seite wegkippen kann. Dies führt zum Beispiel bei Leistungsbauelementen zu einer höheren Belastbarkeit der Bauteile, da die Wärmeabfuhr gleichmäßig über die gelötete Fläche erfolgt. Ein weiterer Vorteil ist, dass das Lot sehr gut an der Unterlage fixiert wird. Es ist sicher gegen ein Verrutschen auch bei Erschütterungen der Unterlage im Montageprozess. So müssen keine gesonderten Maßnahmen mehr getroffen werden, um das Lot vor dem Lötprozess zu fixieren. Ferner ist die Befestigung des Lotes so gut, dass die Unterlage mit dem Lot auf den Kopf gedreht werden kann, ohne dass das Lot sich wieder von der Unterlage löst. Es wird sogar möglich, ein Bauteil "über Kopf" auf der mit Lot bedeckten Unterlage zu befestigen. Es findet keine Bewegung des Bauteils beim Lötprozess mehr statt, wie zum Beispiel ein einseitiges Absinken des Bauteils beim Aufschmelzen des Lots. Überstehende Ecken sowie größerer Versatz beim Auflegen des Bauteils auf die Lotfolie stellen deswegen kein Problem dar. Damit werden insbesondere Kurzschlüsse durch Montageungenauigkeiten vermieden. Ferner können auch Bondverbindungen vorab schon vorhanden sein. Auch Stapelaufbauten für Modulgleichrichter sind lötbar, bei denen mehrer Lötverbindungen übereinander angeordnet werden.

Durch die in den abhängigen Ansprüchen aufgeführten Maßnahmen sind vorteilhafte Weiterbildungen und Verbesserungen des im Hauptanspruch angegebenen Lötverfahrens möglich.

### Zeichnung

Ausführungsbeispiele der Erfindung sind in der Zeichnug dargestellt und in der nachfolgenden Beschreibung näher erläutert. Es zeigen Figur la eine Lotunterlage in Querschnittseitenansicht, Figur 1b eine Lotunterlage in Draufsicht, Figur 2a einen Verfahrensschritt, Figur 2b einen zweiten Verfahrensschritt und Figur 3 einen weiteren Verfahrensschritt.

### Beschreibung der Ausführungsbeispiele

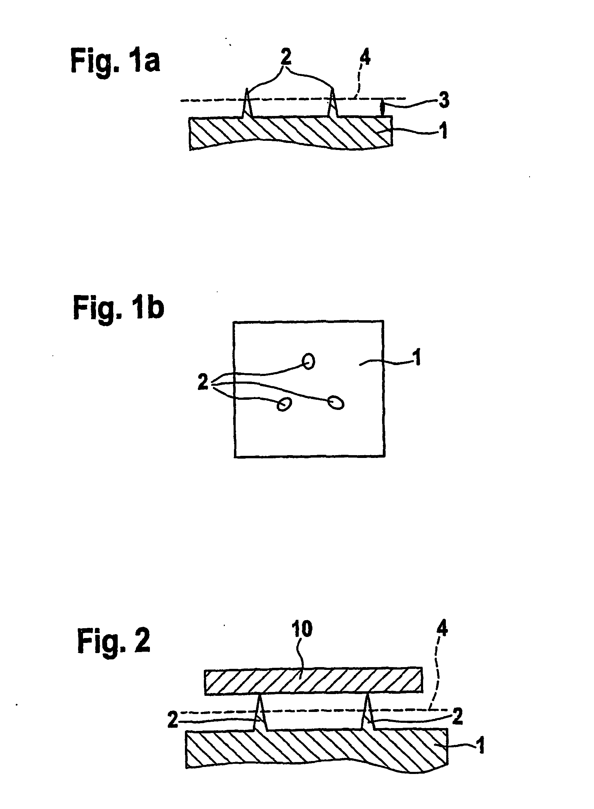

Figur 1a zeigt eine Lotunterlage 1, beispielsweise eine Metalloberfläche, insbesondere einen Leadframe, auf der Erhebungen 2 angeordnet sind. Diese Erhebungen überragen eine angestrebte Höhe einer nachfolgend aufzutragenden Lotschicht; diese Höhe ist mit der gestrichelten Linie 4 und dem Doppelpfeil 3 markiert. In Figur 1b ist in Draufsicht eine Anordnung von drei Erhebungen 2 gezeigt.

Zunächst werden also im Bereich der Auflageposition eines zu lötenden Bauteils Erhebungen 2 in die Oberfläche der Lötunterlage eingeprägt. Dies kann zum Beispiel über einen schrägen Einstich mit einem spitzen Werkzeug, zum Beispiel einer gehärteten Nadel, so erfolgen, dass am Rand des Einstichs eine ausreichend hohe Aufwerfung oder ein Grat entsteht, der dann eine Erhebung 2 bildet. Das aufgeworfene Material der Unterlage sollte dabei mindestens so hoch, typischerweise jedoch etwas höher sein als die einzustellende Lotschichtdicke nach dem Lötprozess. Die Unterlage besteht hierzu aus einem weichen verformbaren Material, zum Beispiel aus vernickeltem Kupfer. Es ist vorteilhaft, mindestens drei Erhebungen zu wählen, da so eine eindeutige Ebene definiert wird.

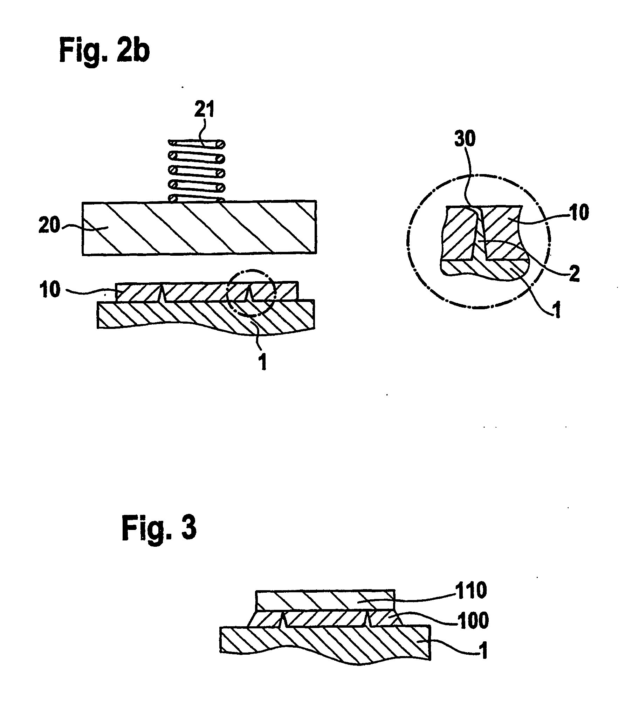

Figur 2 a zeigt, wie eine Lotfolie 10 auf die Erhebungen 2 aufgelegt wird.

Die Lotfolie sollte die Dicke besitzen, die nach dem Lötprozess erreicht werden soll. Die Fläche der Lotfolie muss daher mindestens so gross sein wie die zu lötende Auflagefläche des Bauteils. Ist sie deutlich kleiner als das Bauteil, so entstehen Lunker, da die Lotmenge bei dem durch die Erhebungen vorgegebenem Abstand nicht mehr ausreicht, um die gesamte Fläche zu benetzen.

Figur 2b zeigt, wie mittels eines Druckelements 20 mit einer der Lotfolie zugewandten planaren Fläche unter Aufwendung einer Druckkraft, symbolisiert durch die Druckfeder 21, die Erhebungen niedergedrückt werden.

Dieses Niederdrücken erfolgt vorzugsweise kraftgesteuert, bis die Erhebungen die Höhe der Lotfolie erreicht haben. Sobald die Höhe der Lotfolie erreicht wird, steigt die Kraft zum weiteren Niederdrücken der Erhebungen stark an. Bei diesem Schritt verkrallt sich die Lotfolie mit der niedergedrückten Erhebung derart, dass das Lot an den Erhebungen und damit an der Unterlage fixiert wird. Wie im vergrößerten Ausschnitt in Figur 2b ersichtlich, bilden sich bei den Erhebungen durch diesen Planarisierungsschritt kleine Plateaus 30, die später als Auflageflächen für das Bauteil insbesondere im flüssigen Zustand des Lotes dienen.

In einem weiteren Schritt wird nun das aufzulötende Bauteil 110, wie in Figur 3 gezeigt, auf das Lot aufgelegt und anschließend dem eigentlichen Lötprozess zugeführt. Durch Erhitzung des Lots wird dieses flüssig, und durch die Kapillarkraft des Lotes wird das Lot, das sich ausserhalb der direkten Auflagefläche des Bauteils auf der Lotfolie befindet, unter das Bauteil gezogen, bis sich nach Abkühlung und Erstarrung des Lotes die Lotschicht 100 ausgebildet hat, die das Bauteil 110 mit der Unterlage 1 mechanisch und elektrisch miteinander verbindet.

Alternativ kann das Bauteil auch von unten an die bereits durch die teilweise plattgedrückten Erhebungen fixierte Lotfolie herangeführt werden, also "über Kopf" mit der Unterlage verlötet werden.

Die Erhebungen können statt durch Einprägung auch durch das Aufbonden von kurzen Bonddrahtstücken auf die Unterlage hergestellt werden. Der Draht wird dabei mit seiner Längsachse parallel zur Oberfläche der Lotunterlage 1 aufgebondet. Die Dicke eines Bonddrahtes ist typischerweise etwas größer als die Höhe der einzustellenden Lotschicht zu wählen. Die Bondpositionen entsprechen den Positionen, an denen im in Figur 1 dargestellten Ausführungsbeispiel sich die durch Einkerbungen beziehungsweise Einprägungen erzeugten Erhebungen befinden. Die Erhebungen infolge der kurzen Bonddrahtstücke erfüllen die gleiche Funktion wie die zuvor beschriebenen Erhebungen.

Eine weitere alternative Vorgehensweise besteht darin, beispielsweise Leadframes mit eingebrachten Erhebungen sowie aufgelegter und planarisierter Lotfolie sowie ausgeformten Plateaus der Erhebungen in einen Lötofen einzuführen, bevor das Bauteil, beispielsweise ein Halbleiterchip, aufgelegt wird. Beim Aufheizen des Leadframes über die Schmelztemperatur des Lotes bildet sich eine kissenförmige Lotoberfläche aus. Danach erst wird der Chip positioniert und auf die Plateaus 30 aufgedrückt. Wenn der Chip losgelassen wird, kann er auch in diesem Fall die vorgegebene Lotdicke wegen der vorhandenen Erhebungen in der Leadframeoberfläche nicht unterschreiten, so daß sich kein Lotüberstand neben dem Chip ausbilden kann. Der Chip kann die vorgegebene Dicke wegen der Kapillarkräfte und wegen des begrenzten Lotangebots aber auch nicht wesentlich überschreiten. Das Vorsehen von Erhebungen, einer Lotfolie definierter Dicke und deren anschließendes Anpressen inklusive einer Erzeugung von Plateaus aus den Erhebungen ist also auch im Rahmen eines sogenannten "Soft-Solder-Die-Attach"-Verfahrens vorteilhaft anwendbar, bei dem das zu lötende Bauteil auf ein bereits flüssiges Lotkissen aufgesetzt wird. Nach dem Andrücken auf die Plateaus wird er, wie bereits erwähnt, losgelassen, und nach Abkühlung liegt ebenfalls eine den Chip 110 mit der Unterlage 1 verbindende feste Lotschicht 100 vor. Der verwendete Leadframe darf bei einer derartigen Verwendung allerdings keine Vertiefungen an der mit dem Bauteil zu besetzenden Position haben, da diese ansonsten beim Lötprozess ebenfalls mit Lot gefüllt werden und so die Lotmenge selbst bei einer im Vergleich zum Chip leicht größeren Lotfolie unter Umständen nicht mehr zur vollständigen Benetzung der Chipfläche ausreicht.

## Patentansprüche

1. Verfahren zur Befestigung mindestens eines elektrischen Bauelements auf einer Unterlage unter Verwendung von Lot, wobei
- Erhebungen in der Lotunterlage erzeugt werden, die mindestens so hoch sind wie eine einzustellende Lotschichtdicke,
- in einem weiteren Schritt das Lot, insbesondere eine Lotfolie, auf die Erhebungen aufgelegt wird, **dadurch gekennzeichnet, dass**
- in einem weiteren Schritt die Erhebungen
- zur Einstellung einer erwünschten Lotschichtdicke und
- zur Fixierung des Lots auf der Lotunterlage
derart niedergedrückt werden, bis sie ungefähr die Höhe des Lotes erreicht haben, - in einem weiteren Schritt ein Lötvorgang durchgeführt wird.

2. Verfahren nach Anspruch 1, **dadurch gekennzeichnet, dass** die Erhebungen dadurch niedergedrückt werden, dass eine im wesentliche plane Platte vorzugsweise kraftgesteuert auf die Erhebungen drückt.

3. Verfahren nach Anspruch 1 oder 2, **dadurch gekennzeichnet, dass** die Erhebungen unter Verwendung einer Nadel eingeprägt werden.

4. Verfahren nach Anspruch 1 oder 2, **dadurch gekennzeichnet, dass** die Erhebungen durch Aufbonden von Bonddrähten, insbesondere Aluminiumbonddrähten, aufgebracht werden.

5. Verfahren nach einem der vorhergehenden Ansprüche, **dadurch gekennzeichnet, dass** mindestens drei Erhebungen aufgebracht werden.

6. Verfahren nach einem der vorhergehenden Ansprüche, **dadurch gekennzeichnet, dass** der Lötvorgang in einem ersten Schritt ein Auflegen oder Heranführen des Bauelements umfaßt und dass in einem zweiten Schritt die Lotschicht über ihre Schmelztemperatur erhitzt wird.

7. Verfahren nach Anspruch 6, **dadurch gekennzeichnet, dass** der Lötvorgang in einer Überkopfmontage erfolgt.

8. Verfahren nach einem der Ansprüche 1 bis 5, **dadurch gekennzeichnet, dass** der Lötvorgang in einem ersten Schritt ein Erhitzen der Lotschicht ihre Schmelztemperatur umfaßt und dass in einem zweiten Schritt das Bauelement auf die niedergedrückten Erhebungen gedrückt wird.

## Claims

1. Method for fastening at least one electrical component on a substrate, using solder,
- elevations which are at least as high as the thickness of a solder layer to be produced being generated in the solder substrate,
- in a further step, the solder, especially a solder foil, being laid onto the elevations,
**characterized in that**
- in a further step,
- to produce a desired solder layer thickness and
- to fix the solder on the solder substrate, the elevations are pressed down until they have reached approximately the height of the solder, and
- in a further step, a soldering procedure is carried out.

2. Method according to Claim 1, **characterized in that** the elevations are pressed down by an essentially planar plate pressing on the elevations in a preferably force-controlled manner.

3. Method according to Claim 1 or 2, **characterized in that** the elevations are impressed by using a needle.

4. Method according to Claim 1 or 2, **characterized in that** the elevations are applied by bonding on bonding wires, especially aluminium bonding wires.

5. Method according to one of the preceding claims, **characterized in that** at least three elevations are applied.

6. Method according to one of the preceding claims, **characterized in that** the soldering procedure comprises, in a first step, laying down the component or bringing the component into place and **in that**, in a second step, the solder layer is heated above its melting point.

7. Method according to Claim 6, **characterized in that** the soldering procedure is carried out in an overhead mounting operation.

8. Method according to one of Claims 1 to 5, **characterized in that** the soldering procedure comprises, in a first step, heating the solder layer above its melting point and **in that**, in a second step, the component is pressed onto the pressed-down elevations.

## Revendications

1. Procédé pour fixer au moins un composant électrique sur un support en utilisant un apport de brasage, d'après lequel
- dans le support de brasage on produit des bossages qui sont au moins aussi hauts qu'une épaisseur de couche brasée à obtenir,
- dans une autre étape on applique sur les bossages l'apport de brasage, en particulier une feuille de brasage,
**caractérisé en ce que**
- dans une autre étape, pour obtenir une épaisseur de couche brasée souhaitée et pour fixer l'apport de brasage sur le support de brasage, on aplatit les bossages jusqu'à ce qu'ils atteignent à peu près la hauteur de l'apport de brasage et
- dans une autre étape on réalise une opération de brasage.

2. Procédé selon la revendication 1,
**caractérisé en ce que**
les bossages sont aplatis en pressant sur les bossages une plaque presque plane, de préférence en contrôlant la force.

3. Procédé selon la revendication 1 ou 2,
**caractérisé en ce que**
les bossages sont estampés en utilisant une aiguille.

4. Procédé selon la revendication 1 ou 2,
**caractérisé en ce que**
les bossages sont appliqués en liant des fils de liaison, en particulier des fils de liaison en aluminium.

5. Procédé selon l'une des revendications précédentes,
**caractérisé en ce qu'**
on applique au moins trois bossages.

6. Procédé selon l'une des revendications précédentes,
**caractérisé en ce que**
dans une première étape l'opération de brasage consiste à poser ou à apporter le composant, et dans une deuxième étape la couche brasée est portée au-delà de sa température de fusion.

7. Procédé selon la revendication 6,
**caractérisé en ce que**
l'opération de brasage est réalisée dans un montage « tête à l'envers ».

8. Procédé selon l'une des revendications 1 à 5,
**caractérisé en ce que**
dans une première étape l'opération de brasage consiste à porter la couche brasée au-delà de la température de fusion et dans une deuxième étape le composant est pressé sur les bossages aplatis.
